**Europäisches Patentamt**

**European Patent Office**

**Office européen des brevets**

(11) Veröffentlichungsnummer : **0 551 625 B1**

(12) # EUROPÄISCHE PATENTSCHRIFT

(45) Veröffentlichungstag der Patentschrift :
**19.07.95 Patentblatt 95/29**

(51) Int. Cl.$^6$ : **H01L 29/861**

(21) Anmeldenummer : **92121408.6**

(22) Anmeldetag : **16.12.92**

(54) **Leistungsdiode.**

(30) Priorität : **17.01.92 DE 4201183**

(43) Veröffentlichungstag der Anmeldung :
**21.07.93 Patentblatt 93/29**

(45) Bekanntmachung des Hinweises auf die
Patenterteilung :
**19.07.95 Patentblatt 95/29**

(84) Benannte Vertragsstaaten :
**CH DE FR GB LI**

(56) Entgegenhaltungen :
**EP-A- 0 077 004**
**EP-A- 0 103 138**

(73) Patentinhaber : **EUPEC Europäische
Gesellschaft für Leistungshalbleiter mbH &
Co. KG
Max-Planck-Strasse 5
D-59581 Warstein (DE)**

(72) Erfinder : **Schlangenotto, Heinrich, Dr. rer. nat.
Jahnstrasse 34
W-6078 Neu Isenburg (DE)**
Erfinder : **Sommer, Karl Heinz, Dr. rer. nat.
Goethestrasse 12
W-4788 Warstein (DE)**
Erfinder : **Kaussen, Franz, Dr. rer. nat.
Brucknerweg 29
W-4788 Warstein (DE)**

(74) Vertreter : **Fuchs, Franz-Josef, Dr.-Ing.
Postfach 22 13 17
D-80503 München (DE)**

## Beschreibung

Die Erfindung bezieht sich auf eine Leistungsdiode mit mindestens einem Halbleiterkorper, der eine Innenzone vom ersten Leitfähigkeitstyp und gegebener Dotierungshöhe hat, eine Katodenzone vom ersten Leitfähigkeitstyp und höherer Dotierung als die Innenzone, eine Anodenzone vom entgegengesetzten, zweiten Leitfähigkeitstyp und höherer Dotierung als die Innenzone und bei dem die Innenzone mindestens zwei Bereiche hat, von denen der erste eine erste vorgegebene Dicke und der zweite eine zweite, um mindestens den Faktor 1,4 größere Dicke aufweist, wodurch zwei Teildioden definiert werden.

Eine solche Leistungsdiode ist z. B. in der Europäischen Patentanmeldung 0 077 004 beschrieben worden. Dabei soll durch die Teildiode, deren Innenzone die geringere Dicke hat, eine geringe Verlustleistung in Durchlaßrichtung und eine hohe Geschwindigkeit möglich sein. Auf der anderen Seite soll die Sperrspannung durch die Diode mit der dickeren Innenzone aufgenommen werden.

Gleichrichterdioden für die Leistungselektronik haben eine PNN$^+$-Dotierungsstruktur, bestehen also aus einer in der Mitte liegenden, schwach dotierten Innenzone, die im allgemeinen N-Leitfähigkeit besitzt, und zwei sich außen anschließenden höher dotierten Zonen vom P- bzw. N-Leitfähigkeitstyp. Schnelle Dioden werden außerdem mit Rekombinationszentren wie Gold, Platin dotiert oder es werden durch Elektronen- oder Gammabestrahlung Glitterdefekte erzeugt, um die Ladungsträgerlebensdauer zu erniedrigen oder dadurch die dynamischen Eigenschaften zu verbessern. Von schnellen Leistungsdioden wird vor allem gefordert, daß bei Kommutierung aus dem Durchlaßzustand das Rückstrommaximum klein sein und der Abfall des Rückstroms nach dem Rückstrommaximum mit nicht zu großer Steilheit erfolgen soll (weiches Rückwärtserholungs- oder Soft-Recovery Verhalten). Durchlaßspannung und Sperrstrom dürfen dabei bestimmte Werte nicht überschreiten.

Ein bekanntes Verfahren, das Recovery-Verhalten bis zu einem gewissen Grad weich zu machen, besteht darin, die Basiszone wesentlich dicker einzustellen als es für das gewünschte Sperrvermögen erforderlich ist. Dadurch wird erreicht, daß zum Zeitpunkt der Rückstromspitze und des darauf folgenden Maximums der Rückwärtsspannung noch soviel Ladungsträger in der Struktur vorhanden sind, daß ein Abreißen des Rückstroms vermieden wird. Jedoch ist der Grad des Soft-Recovery-Verhaltens, das so erreicht wird, noch relativ gering. Ein mindestens ebenso großer Nachteil dieser Methode besteht aber darin, daß durch die Vergrößerung der Basisdicke der maximale Rückstrom $i_{RM}$ stark erhöht wird, wenn die Durchlaßspannung UF unverändert bleiben soll bzw. sich ein größerer $U_F$ Wert ergibt, wenn $i_{RM}$ unverändert bleiben soll. Beides ist unerwünscht.

Es ist weiter bekannt, daß man ein weicheres Recovery-Verhalten und gleichzeitig eine kleinerer Rückstromspitze erreichen kann, indem man die integrale Dotierung der P-Zone, die üblicherweise in der Größenordnung 10$^{16}$/cm$^2$ liegt, bis auf eine Untergrenze von etwa $1*10^{13}$/cm$^2$ reduziert. Dabei werden vorteilhaft hoch dotierte P$^+$-Inseln in die P-Zone eingefügt, um die Durchlaßspannung bei hohen Strömen klein zu halten (man vgl. DE-A-36 33 161). Auch bei diesem Verfahren muß die Basisdicke größer gewählt werden, als für das angestreble Sperrvermögen erforderlich ist, da sonst die Speicherladung vorzeitig ausgeräumt wird und der Rückstrom hart abreißt. Die Vergrößerung der Basisdicke ist auch hier mit einer Erhöhung der Rückstromspitze bzw. von $U_F$ verbunden.

Zur Verbesserung des Recovery-Verhaltens von Leistungsdioden wird in der EP-A-009 0722 eine Halbleiterstruktur beschrieben, bei welcher zwischen der schwach dotierten n-leitenden Basiszone und dem hoch dotierten N$^+$-Gebiet eine N-Zone mittlerer Dotierungskonzentration angeordnet ist, die in dem Bereiche 10$^{14}$ bis 10$^{16}$/cm$^3$ liegt. Hierdurch kann ebenfalls eine relativ kleine Rückstromspitze und ein weiches Recovery-Verhalten erzielt werden. Jedoch ist für die Herstellung einer solchen Struktur ein zweistufiger Epitaxie-Prozeß erforderlich, der bei höher sperrenden Dioden hohe Kosten verursacht. Außerdem ist das Recovery-Verhalten noch nicht so gut, wie es für viele Anwendungen gewünscht wird.

Die bekannten Dioden besitzen auch den Nachteil, daß sie in der Regel ihre Funktionsfähigkeit verlieren, wenn die Spannung während einer schnellen Kommutierung in der Nähe der Durchbruchspannung kommt. Durch hochfrequente Schwingungen und elektromagnetische Interferenz werden dabei auch andere Bauelemente in der Schaltung gefährdet.

Der Erfindung liegt die Aufgabe zugrunde, das Recovery-Verhalten von Leistungsdioden weiter zu verbessern. Insbesondere soll der maximale Rückstrom ohne Beeinträchtigung des Soft-Recovery-Verhaltens über das bisher erreichte Maß hinaus reduziert werden. Außerdem soll eine Zerstörung der Bauelemente verhindert werden, wenn die Spannung beim Kommutieren in den Durchbruchbereich kommt, d. h. es soll Durchbruch- oder Avalanchefestigkeit erreicht werden.

Diese Aufgabe wird dadurch gelöst, daß die Dicke des ersten Bereichs der geforderten Sperrspannung entspricht und daß die Fläche und die Minoritätsträgerlebensdauer der ersten und zweiten Teildiode so bemessen sind, daß der durch die erste Teildiode fließende Strom in der Durchlaßphase mindestens um den Faktor 2 größer ist als der durch die zweite Teildiode fließende Strom.

EP 0 551 625 B1

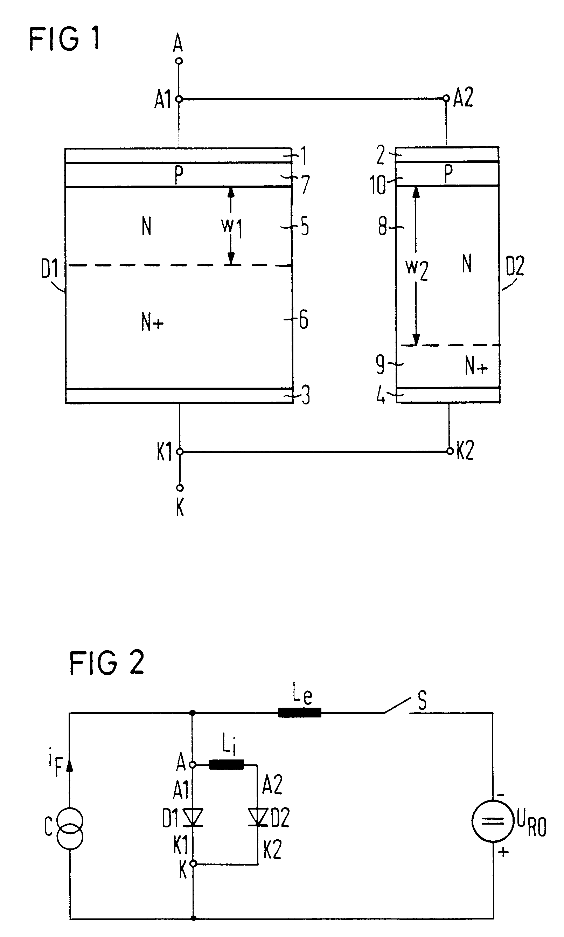

Die Erfindung wird anhand von Ausführungsbeispielen in Verbindung mit den Figuren 1-10 näher erläutert. Es zeigen:

| | |
|---|---|
| Figur 1 | das Prinzip der Erfindung |
| Figur 2 | eine Schaltungsanordnung zur Erläuterung des Kommutierungsvorgangs bei einer Diode gemäß Erfindung |
| Figur 3 | ein Diagramm zur Erläuterung des Kommutierungsvorgangs |
| Figur 4 | eine Gegenüberstellung des Kommutierungsvorgangs bei Dioden nach Stand der Technik und nach der Erfindung |
| Figur 5 | die Dotierungs- und Ladungsträgerkonzentrationen bei einem Ausführungsbeispiel |
| Figur 6 | einen möglichen mechanischen Aufbau einer Diode |
| Figur 7 | ein Diagramm zur Erläuterung des Kommutierungsvorgangs, wenn in einer Teildiode die Durchbruchspannung erreicht wird |
| Figur 8 | einen Schnitt durch ein erstes Ausführungsbeispiel |
| Figur 9 | Verfahrensschritte zum Herstellen des Ausführungsbeispiels nach Figur 8 |
| Figur 10 | einen Schnitt durch ein zweites Ausführungsbeispiel. |

In Figur 1 ist zur Erläuterung des Erfindungsprinzips eine Diode dargestellt, die in zwei Teildioden D1, D2 unterteilt ist, die beide eine $PNN^+$-Zonenfolge bilden. Die N-dotierte Innenzone 5 der Teildiode D1 hat eine geringe Dicke w1, die Innenzone 8 der Teildiode D2 hat eine größere Dicke w2. Die $N^+$-Zonen 6, 9 der Teildioden sind zur ohmschen Kontaktierung mit Metallschichten 3, 4 versehen. Diese sind mit Katodenanschlüssen K1 und K2 verbunden, welche zur Katode K der Diodeneinheit führen. Ebenso sind die P-Zonen 7, 10 in ohmscher Weise mit Metallschichten 1, 2 versehen, die mit Anodenanschlüssen A1 und A2 der Teildioden D1 bzw. D2 verbunden sind und über diese in Kontakt mit dem Anodenanschluß A der Diodeneinheit stehen. Die Dotierungskonzentration in entsprechenden Zonen der beiden Teildioden ist als gleich angenommen. Wie bei herkömmlichen Dioden wird die Dotierungskonzentration der P-Zonen vorzugsweise wesentlich kleiner eingestellt als die der $N^+$-Zone, z. B. mit einer integralen Dotierungskonzentration von $5*10^{12}/cm^3$ bis $1*10^{14}/cm^2$, um ein weiches Recovery-Verhalten der Diodeneinheit zu erhalten. Um das Durchlaßverhalten bei hohen Strömen zu verbessern, können hochdotierte $P^+$-Bereiche in die P-Zone eingebaut sein, wie z.B. in der DE-A-36 33 161 vorgeschlagen wurde.

Daß durch eine solche Diode wesentliche Verbesserungen erreicht werden können, beruht auf folgender Erkenntnis: Die Speicherladung $Q_F$, die in der Diode insgesamt in der Durchlaßphase gespeichert wird, kann gegenüber einer bekannten Diode gleicher Durchlaßspannung stark abgesenkt werden. Dies überträgt sich auf die durch den Rückstrom extrahierte Ladung $Q_r$, die abzüglich eines Rekombinationsanteils durch $Q_F$ mitbestimmt ist.

Die verminderte Ladung $Q_r$ läßt sich dabei gleich günstig auf die nach der Rückstromspitze während der Fallphase extrahierte Speicherladung $Q_{rf}$ und die bis zur Rückstromspitze extrahierte Ladung $Q_{rs}$ verteilen, so daß der sog. Softfaktor $S = t_f/t_s = Q_{rf}/Q_{rs}$ ($t_f$ = Fallzeit, $t_s$ = Speicherzeit) der Diodeneinheit gleich dem einer optimierten Einzeldiode ist, die zum Vergleich dient. Bei gleichem Durchlaß-, Sperr- und Soft-Recovery-Verhalten weist die erfindungsgemäße Diodeneinheit damit einen wesentlich kleineren Rückstrom auf als die Referenz-Diode.

Dies soll nun zusammen mit der erforderlichen Dimensionierung genauer ausgeführt werden. Die Speicherladung $Q_F$ einer Diode in der Durchlaßphase ist näherungsweise gegeben durch

$$1) \qquad Q_F = \frac{i_F\, W^2}{(\mu_n + \mu_p)\, U_{ohm}}$$

Hierbei bezeichnen $\mu_n$ und $\mu_p$ die Beweglichkeiten der Elektronen bzw. Löcher, $i_F$ den Durchlaßstrom, $U_{ohm}$ den ohmschen Spannungsabfall und W die Dicke des von Ladungsträgern überschwemmten Mittelgebietes (effektives Basisgebiet). Da dieses außer der Basiszone auch benachbarte Bereiche der Endgebiete umfaßt, soweit die Minoritätsträgerkonzentration dort bei diffundierten Endgebieten größer ist als die Dotierungskonzentration, ist die effektive Basisdicke W im allgemeinen größer als die eigentliche Basisdicke w. Die Beziehung 1) gilt bei der Diodeneinheit für jede der Teildioden, deren Durchlaßströme mit $i_{F1}$, $i_{F2}$ und deren Speicherladungen mit $Q_{F1}$, $Q_{F2}$ bezeichnet werden. Für die Speicherladung $Q_F = Q_{F1} + Q_{F2}$ der Diodeneinheit mit dem Durchlaßstrom $i_F = i_{F1} + i_{F2}$ folgt somit aus Gl. 1):

$$2) \qquad Q_F = \left(\frac{i_{F1}}{i_F}\left(\frac{W_1}{W_2}\right)^2 + \frac{i_{F2}}{i_F}\right) Q_{F0}$$

wobei $Q_{F0} = i_F\, W_2^2 / ((\mu_n + \mu_p)\, U_{ohm})$. Die Basisdicke der Teilzone D2, die das Soft-Verhalten gewährleisten soll, wählt man gleich der Basisdicke einer Diode mit soft-recovery-Verhalten. Daher bedeutet $Q_{F0}$ die Speicherladung dieser Vergleichsdiode, die sich von D2 nur dadurch unterscheidet, daß sie bei dem ohmschen Spannungsabfall $U_{ohm}$, den die Teildioden für die Teilströme aufweisen, den Gesamtstrom $i_F$ führt. Wegen der gleichen Durchlaßspannung der Teildioden und der Referenzdiode darf auch der ohmsche Spannungsanteil $U_{ohm}$ in guter Näherung gleich gesetzt werden.

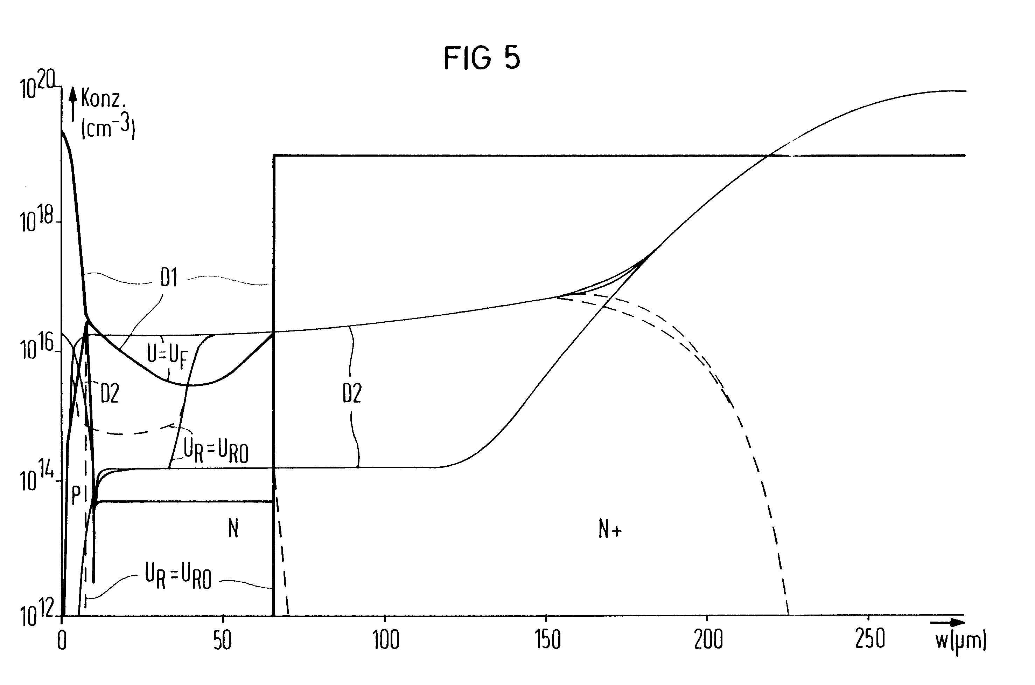

Bei einer Diode mit Soft-Recovery-Verhalten muß man die Basisdicke $w_2$ zur Vermeidung eines harten Rückstromabfalls wenigstens gleich dem 1,4-fachen Mindestbasisdicke $w_{min}$ für das geforderte Sperrvermögen wählen. Optimal ist oft ein Verhältnis von zwei. Macht man $w_{min}$ durch Herabsetzung der Dotierungskonzentration des Basisgebietes so klein wie möglich (Nähe pin-Fall), so ist $w_2/w_{min}$ sogar größer als 2 anzusetzen. Auch das Verhältnis der effektiven Basisdicken $W_2/W_1$ der Teildioden kann man daher ein Optimum mindestens gleich 2 wählen; in dem unten beschriebenen Ausführungsbeispiel für eine 1000 V-Diode (s. Figur 5) ist $W_2/W_1$ gleich 2.9. Mit $W_2/W_1 = 2$ erhält man aus Gl. 2) für die Speicherladung $Q_F$ der Diodeneinheit je nach der Stromaufteilung auf die beiden Teildioden einen Wert zwischen $Q_{F0}/4$ und $Q_{F0}$. Für $i_{F1} = 0.8\ i_F$, $i_{F2} = 0.2\ i_F$ ergibt sich $Q_F = 0.4\ Q_{F0}$.

Nun ist zu erläutern, wie der Strom und die Speicherladung auf die beiden Teildioden aufzuteilen sind, damit sich ein gutes Recovery-Verhalten ergibt. Zunächst wird der Kommutierungsvorgang der erfindungsgemäßen Diode allgemein erläutert. Hierzu wird auf die in Figur 2 gezeigte Schaltung verwiesen. Aus einer Stromquelle C fließt ein Durchlaßstrom $i_F$. Durch Schließen des Schalters S wird dann eine rückwärts gerichtete Kommutierungsspannung $U_{R0}$ an die Diodeneinheit gelegt, die mit einer externen Streuinduktivität $L_e$ in Serie liegt. Innerhalb der Diodeneinheit D kann vor der Teildiode D2 noch eine Streuinduktivität $L_i$ liegen, wie später erläutert wird.

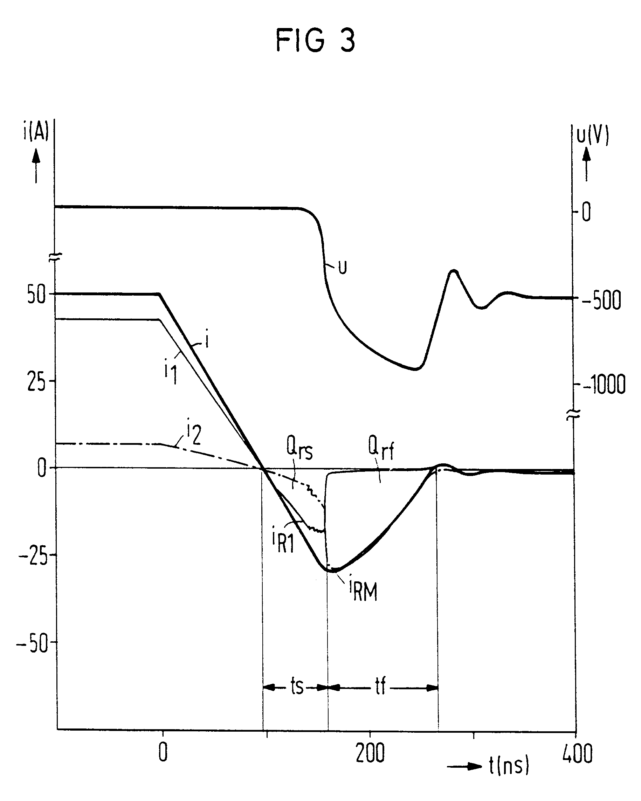

Die zeitlichen Verläufe der Ströme und der Spannung, die bei einer solchen Kommutierung auftreten, sind in Figur 3 dargestellt. Hier wurde eine Diode mit 1100 V Sperrspannung und 50 A Nennstrom zugrundegelegt. Mit i ist der Gesamtstrom bezeichnet, $i_1$ und $i_2$ sind die Ströme durch die Teildioden; U ist die Spannung, die an der Diode, also auch an den Teildioden liegt. Es fließe zunächst ein Durchlaßstrom von 50 A, der zu 85 % durch die Teildiode D1 mit der dünnen Basiszone und zu 15 % durch die Teildiode D2 mit der dicken Basiszone fließt. Zur Zeit t = 0 wird der Schalter S geschlossen und durch die Spannung $U_{R0} = 500$ V wird der Strom mit der Steilheit $-\ di/dt = U_{R0}/L_e = 500\ A/\mu s$ in die Sperrichtung kommutiert. Die interne Induktivität $L_i$ wurde hierbei weggelassen. Nach dem Stromnulldurchgang fließt solange ein hoher Rückstrom, wie sich Speicherladung in den Teildioden befindet. Infolge der dünnen Basiszone der Teildiode D1 ist die Speicherladung aus dieser Diode schon bei einer Rückwärtsspannung von etwa 200 V weitgehend entfernt. Der Rückstrom $i_{R1}$ aus dieser Diode reißt daher bald ab und erreicht auch nur einen kleinen Spitzenwert. Die extrahierte Ladung $Q_{r1} = \int i_{R1}\ dt$ ist dabei wesentlich kleiner als die Speicherladung $Q_{F1}$ in der Durchlaßphase, da die Minoritätsträgerlebensdauer in der Diode D1 sehr klein eingestellt werden muß, um bei der geringen Basisdicke nicht einen viel größeren Unterschied in den Strömen $i_{F1}$ und $i_{F2}$ zu bekommen.

In der Diode D2 ist dagegen wegen der größeren Basisdicke zum Zeitpunkt des Stromabrisses der Diode D1 noch ein großer Teil ihrer anfänglichen Speicherladung $Q_{F2}$ enthalten. Wie aus Figur 3 zu ersehen, wird der Gesamtrückstrom der Diodeneinheit daher schnell von dieser Teildiode D2 übernommen, veranlaßt durch einen starken Spannungsanstieg. Da diese Diode nur einen relativ kleinen Durchlaßstrom führte, ist ihre Speicherladung trotz der größeren Basisdicke mit der Speicherladung $Q_{F1}$ der Teildiode D1 vergleichbar (s. Gl.2)). Das Rückstrommaximum der Diodeneinheit ist daher gegenüber dem Fall einer herkömmlichen soft-recovery-Diode stark reduziert. Dies ist der Fall, obgleich die Teildiode D2 vor dem Rückstrommaximum eine sehr hohe Stromsteilheit $\left|di_2/dt\right|$ aufweist. Von der Teildiode D2 aber übernimmt die Gesamtdiode D das weiche Recovery-Verhalten, wie Figur 3 ebenfalls zeigt.

Zur Zeit der Rückstromspitze $i_R = i_{RM}$ liegt an den beiden Teildioden die Rückspannung $U_R = U_{R0}$, da die Spannung an der Induktivität $L_e$ verschwindet. Das Rückstromintegral $Q_{rs} = \int i_R\ dt$ bis zu diesem Zeitpunkt besteht zum einen Teil aus dem vollen Rückstromintegral $Q_{r1} = \int i_{R1}\ dt = a\ Q_{F1}$ der Diode D1, wobei der Faktor a < 1 den Rekombinationsverlust berücksichtigt. Zum anderen Teil enthält $Q_{rs}$ den aus der Teildiode D2 schon extrahierten Anteil $e\ Q_{F2}$, wobei der Faktor e der Ausdehnung der Raumladungszone bei der Spannung $U_{R0}$ im Verhältnis zur gesamten effektiven Basisdicke $W_2$ entspricht. Somit ist

$$3)\qquad Q_{rs} = a\ Q_{F1} + e\ Q_{F2}$$

Für das Rückstromintegral $Q_{rf}$ über die Fallphase nach dem Rückstrommaximum steht dagegen die Restspeicherladung $(1 - e)\ Q_{F2}$ der Diode D2 zur Verfügung:

$$4)\quad Q_{rf} = (1 - e)\ Q_{F2}$$

Da ein weicher Rückstromabfall und eine kleine Rückstromspitze für das Recovery-Verhalten etwa gleich wichtig sind, darf man als Bedingung für optimales Erholungsverhalten $Q_{rf} = Q_{rs}$ setzen. Mit (3) und (4) ergibt sich daraus folgende Bedingung für die in der Durchlaßphase gespeicherten Ladungen der beiden Teildioden:

$$5)\qquad Q_{F2} = \frac{a}{(1 - 2e)}\ Q_{F1}$$

a und e haben für die Teildioden typischerweise Werte in dem Bereich $0.4 \pm 0.15$ bzw. $0.3 \pm 0.15$. Damit erhält man aus (5), daß die Speicherladungen der beiden Teildioden im Durchlaß bevorzugt annähernd gleich ein-

<div align="center">4</div>

gestellt werden. Aber auch in dem ganzen Bereich $0.5\ Q_{F1} \leqq Q_{F2} \leqq 2\ Q_{F1}$ erhält man deutlich verbesserte Recovery-Eigenschaften der Diodeneinheit.

Um $Q_F$ in den beiden Teildioden gleich einzustellen, müssen sich die Durchlaßströme $i_{F1}$ und $i_{F2}$ der beiden Teildioden zueinander nach Gl. 1) näherungsweise umgekehrt proportional zum Quadrat ihrer effektiven Basisdicken verhalten:

$$6) \qquad i_{F2}/i_{F1} \approx (W_1/W_2)^2$$

Mit $W_1/W_2 = 1/2$ folgt daraus, daß die Teildiode D2 nur etwa 1/4 des Stroms der Diode D1 führen soll. Je nach dem Verhältnis $W_1/W_2$ und den Werten für a und e in Gl. 5) können aber auch andere Werte zweckmäßig sein. Meistens liegt der optimale Wert von $i_{F2}/i_{F1}$ zwischen 1/4 und 1/8.

Diese Ströme können bei gegebener Dotierungsstruktur durch die Fläche und die Minoritätsträgerlebensdauer jeder der Teildioden eingestellt werden. Da somit zwei Parameter für die Einstellung einer Größe, nämlich des Stromes, vorhanden sind, bleibt zunächst ein Freiheitsgrad zur freien Verfügung. Jedoch gehen die Fläche und die Lebensdauer nicht nur in den Strom und damit die Speicherladung der Diode ein. Sie gehen auch in die Größen a und e ein, die nach den Gleichungen 3), 4) die bis zur Rückstromspitze extrahierte Speicherladung $Q_{rs}$ und die Nachlaufladung $Q_{rf}$ mitbestimmen. Den Faktor e, d. h. den bis zur Rückstromspitze ausgeräumten Anteil der Speicherladung der Diode D2 kann man klein machen, indem man die Fläche $A_2$ dieser Diode klein wählt, was zur Konstanthaltung von Strom und Durchlaßspannung mit einer Heraufsetzung der Lebensdauer gekoppelt sein muß. Durch die kleine Fläche ergibt sich in der Diode D2 während der Rückstromphase eine hohe Stromdichte, die eine entsprechend hohe Raumladung durch die Löcher und Elektronen verursacht. Dies ist auch an dem in Figur 5 dargestellten Ausführungsbeispiel zu erkennen. Bis zur Rückstromspitze mit der Spannung $U_R = U_{R0}$ ist die Teildiode D2 daher erst bis zu einer geringeren Weite ausgeräumt als bei größerer Fläche und geringerer Rückstromdichte. Das führt zu einer Verkleinerung der Rückstromspitze. Da die Speicherladung aus D2 außerdem nach Gl. 4) in größerem Maße für die Fallphase nach der Rückstromspitze zur Verfügung steht, wird zusätzlich das Recovery-Verhalten durch die Verkleinerung von $A_2$ weicher.

Allerdings ist diese Verbesserungsmöglichkeit nur in begrenztem Maße anwendbar, weil die erhöhte Raumladung in der Umgebung der Rückstrom- und Rückspannungsspitze eine erhöhte Feldstärke zur Folge hat. Die dadurch verursachte Stoßionisation und Lawinenbildung darf während der Kommutierung nicht zum Durchbruch führen und auch den Rückstrom nicht so erhöhen, daß der positive Effekt überkompensiert wird. Es hat sich gezeigt, daß man die Fläche $A_2$ in der Regel so klein machen darf, daß die Durchlaßstromdichte $i_{F2}/A_2$ maximal etwa 300 A/cm$^2$ beträgt. Die Stromdichte in der Umgebung des Rückstrommaximums der Teildiode D2 aber liegt bei schnellen Kommutierungen um ein Mehrfaches darüber (s. Figur 3).

Bei der Teildiode D1 dagegen wirkt sich eine große Fläche günstig auf das Rückwärtserholungsverhalten der Gesamtdiode aus. Da Strom und Spannung im Durchlaß vorgegeben sind, ist bei einer Vergrößerung der Fläche $A_1$ die Minoritätsträgerlebensdauer in D1 herabzusetzen. Infolge erhöhter Rekombination verringert sich dadurch die extrahierte Ladung $Q_{r1} = a\ Q_{F1}$. Somit wird die in der Speicherphase extrahierte Ladung $Q_{rs} = a\ Q_{F1} + e\ Q_{F2}$ und damit das Rückstrommaximum mit steigender Fläche $A_1$ und abnehmbarer Fläche $A_2$ kleiner. Eine obere Grenze für $A_1$ ergibt sich nicht nur durch die Kosten, sondern auch dadurch, daß eine Absenkung der Lebensdauer unter einen bestimmten Wert auch Nachteile mit sich bringt. Diese bestehen in einem erhöhten stationären Sperrstrom bei hoher Temperatur und darin, daß die hohe Zahl an Rekombinationszentren die Raumladung zu stark erhöhen und damit das Sperrvermögen reduzieren kann.

Oft ist es zweckmäßig, die Fläche $A_1$ der Teildiode mit dem hohen Durchlaßstrom so groß und die Fläche $A_2$ der Teildiode mit dem kleinen Durchlaßstrom so klein zu wählen, daß die Durchlaßstromdichten in beiden Dioden annähernd gleich sind. Wegen der Beziehung 1) bedeutet dies, daß die Flächen der beiden Teildioden bevorzugt entsprechend

$$7) \qquad A_2/A_1 \approx i_{F2}/i_{F1} \approx (W_1/W_2)^2$$

gewählt werden. Praktisch wird die Fläche der Diode D2 meistens in den Bereich 1/3 bis 1/15 von $F_1$ gelegt.

Um die Ströme und Flächen der beiden Teildioden in der angegebenen Weise einzustellen, also um die Durchlaßstromdichte in der Teildiode D2 so groß zu machen wie in der Teildiode D1, ist die Minoritätsträgerlebensdauer in der Diode D2 in typischen Fäller etwa eine Größenordnung höher zu wählen als in der Diode D1. Der Rekombinationsverlust an Speicherladung kann daher bei der Diode D2 im allgemeinen vernachlässigt werden (a = 1), wie oben geschehen.

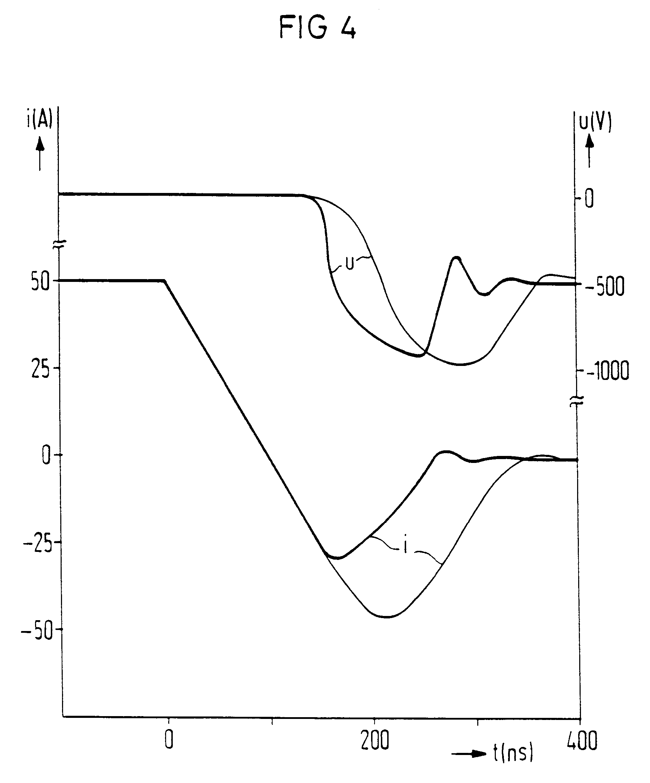

Die erhaltenen Verbesserungen im Recovery-Verhalten werden in Figur 4 verdeutlicht, wo Strom- und Spannungsverlauf beim Kommutieren der erfindungsgemäßen Diode (dick ausgezogen) denen einer bekannten Diode (dünn ausgezogen) gegenübergestellt werden. Der maximale Rückstrom ist auf fast die Hälfte desjenigen der bekannten Diode reduziert. Die maximale Spannung, die sich aus der Kreisspannung $U_{R0}$ und der an der Induktivität $L_e$ im Punkt größter Stromsteilheit induzierten Spannung zusammensetzt, ist nahezu gleich geblieben.

5

Wie schon angedeutet, ist es zweckmäßig, die Dotierungskonzentration $N_{D1}$ der dünneren Basis kleiner zu wählen als die Basisdotierung $N_{D2}$ der Diode D2. $N_{D1}$ soll deutlich kleiner als der bei dem jeweiligen Sperrvermögen maximal zulässige Wert $N_{Dmax}$ sein, während die Dotierungskonzentration der dickeren Basis diesem Wert nahekommen soll. In der Teildiode D1 hat die örtliche Verteilung des elektrischen Feldes bei Spannungen in der Nähe des Sperrvermögens dann die Form eines Trapezes, das sich dem Rechteck annähert. Dadurch wird die für das Sperrvermögen erforderliche Mindestdicke so klein wie möglich. Die höhere Basisdotierung der Teildiode D2 dagegen verhindert ein unnötig weites Vordringen der Raumladungszone in der Diode D2. Dadurch wird die Restladung, die zu den Zeitpunkten des Rückstrommaximums und der maximalen Rückwärtsspannung in der Basis von D2 noch vorhanden ist, möglichst groß gemacht, ohne $w_2$ zu vergrößern. Gegenüber dem Fall gleicher Basisdotierung der beiden Teildioden wird auf diese Weise noch eine beachtliche Reduzierung des maximalen Rückstroms $i_{RM}$ der Gesamtdiode bei gleichem Softfaktor erzielt. Aus Gründen, die mit der Oberflächenpassivierung zusammenhängen, darf man sich dem Fall $N_{D1} = 0$ und $N_{D2} = N_{Dmax}$ nicht beliebig nähern. Praktisch bevorzugte Werte sind $N_{D1} = 0{,}2 - 0{,}5\ N_{D1max}$ und $N_{D2} = 0{,}6 - 0{,}9\ N_{D2max}$.

Die P-Zonen der beiden Teildioden waren, wie im Zusammenhang mit Figur 1 erläutert, als gleich und relativ schwach dotiert angenommen worden. Das Recovery-Verhalten läßt sich demgegenüber noch verbessern, indem man nur die P-Zone der Diode D2 schwach dotiert, die p-leitende Zone der Diode D1 dagegen hoch dotiert. Die Oberflächenkonzentration dieser Zone beträgt z. B. $2*10^{19}/cm^3$, die integrale Dotierung $1*10^{16}/cm^2$. Die p-leitende Zone der Teildiode D2 hat dagegen eine Dotierungskonzentration an der Oberfläche von z. B. $2*10^{16}/cm^3$; die integrale Dotierungskonzentration liegt vorzugsweise in dem Bereich $5*10^{12}/cm^2$ bis $10^{14}/cm^2$. Infolge der hohen Dotierung der p-leitenden Zone der Teildiode D1 ist die Minoritätsträgerlebensdauer in der Diode D1 noch kleiner zu wählen als im Fall der Figur 1, damit die Durchlaßspannung bei den gewählten Strömen $i_{F1}$, $i_{F2}$ genau so groß wird wie bei der Diode mit der dickeren Basis und der schwachen Dotierung der P-Zone. Durch die sehr kleine Lebensdauer in der Diode D1 wird ein noch größerer Teil der Speicherladung $Q_{F1}$ dem Rückstrom durch Rekombination entzogen. Mit Verkleinerung des Faktors a wird die bis zur Rückstromspitze extrahierte Ladung $Q_{rs} = a\ Q_{F1} + e\ Q_{F2}$ und somit auch das Rückstrommaximum $i_{RM}$ reduziert. Wenn eine Herabsetzung der Lebensdauer wegen der erwähnten Nachteile nicht zweckmäßig ist, kann die Fläche $A_1$ gegenüber dem Fall kleiner p-Dotierung der Diode D1 verkleinert werden.

Ein Vorteil der in Verbindung mit Figur 1 erläuterten gleichen Dotierung der p-dotierten Anodenzonen besteht jedoch darin, daß die Durchlaßcharakteristik der Diode D1 wegen der geringen p-Dotierung weniger von der Lebensdauer und damit weniger von der Temperatur abhängt. Somit ist auch die Aufteilung des Gesamtdurchlaßstroms auf die beiden Teildioden weniger temperaturabhängig, so daß das Recovery-Verhalten der Diodeneinheit sich bei geeigneter Einstellung für einen größeren Temperaturbereich nahe dem Optimum befindet.

Ein Diagramm mit Dotierungs- und Ladungsträgerkonzentrationen ist für den Fall einer Diode mit einer höheren Dotierung der Anodenzone von D2 gegenüber der Anodenzone von D1 in Figur 5 dargestellt. Für die beiden Teildioden sind die Dotierungskonzentrationen sowie die Ladungsträgerkonzentrationen in der Durchlaßphase und zur Zeit des Rückstrommaximums dargestellt. Die Dotierungsstruktur ist auf ein betriebsmäßig nutzbares Sperrvermögen von 1000 V ausgelegt. Die Basisdotierung ist bei der Diode D1 mit $N_D = 5*10^{13}/cm^3$ deutlich geringer als bei der Diode D2 mit $1.5*10^{14}/cm^3$. Die Basisdicken stehen im Verhältnis 1 zu 2.2. Die Diode D1 hat eine hohe P-Zonendotierung, die Diode D2 eine um drei Zehnerpotenzen geringere. Der $NN^+$-Dotierungsverlauf der Diode D1 ist der einer Epi-Diode mit der $N^+$-Zone als Substrat. Bei der Diode mit der dickeren Basis hat die $N^+$-Zone ein Diffusionsprofil. Die Ladungsträgerverteilung in der Durchlaßphase wurde für einen Gesamtdurchlaßstrom von 50 A berechnet, der zu 85 % von der Teildiode D1 und zu 15 % von D2 geführt wird. Die Fläche von D1 beträgt 30 mm², die von D2 4 mm². Die Durchlaßspannung wurde auf 2.0 V bei Zimmertemperatur eingestellt. Die dazu erforderliche Lebensdauer in der Basiszone bei hoher Injektion beträgt bei der Diode D1 40 ns, bei der Diode D2 850 ns. Das im Durchlaß überschwemmte effektive Basisgebiet der Diode D2 hat eine Dicke $W_2$, die um den Faktor 2.9 größer ist als diejenige der Diode D1. Wie man weiter sieht, ist die Speicherladung der Diode D2 zur Zeit des Rückstrommmaximums erst zu etwa 1/5 ausgeräumt ($e \approx 0.2$). Die in Figur 5 dargestellten Größen wurden auch für das in Figur 3 gezeigte Recovery-Verhalten (für 125 ° C) zugrunde gelegt.

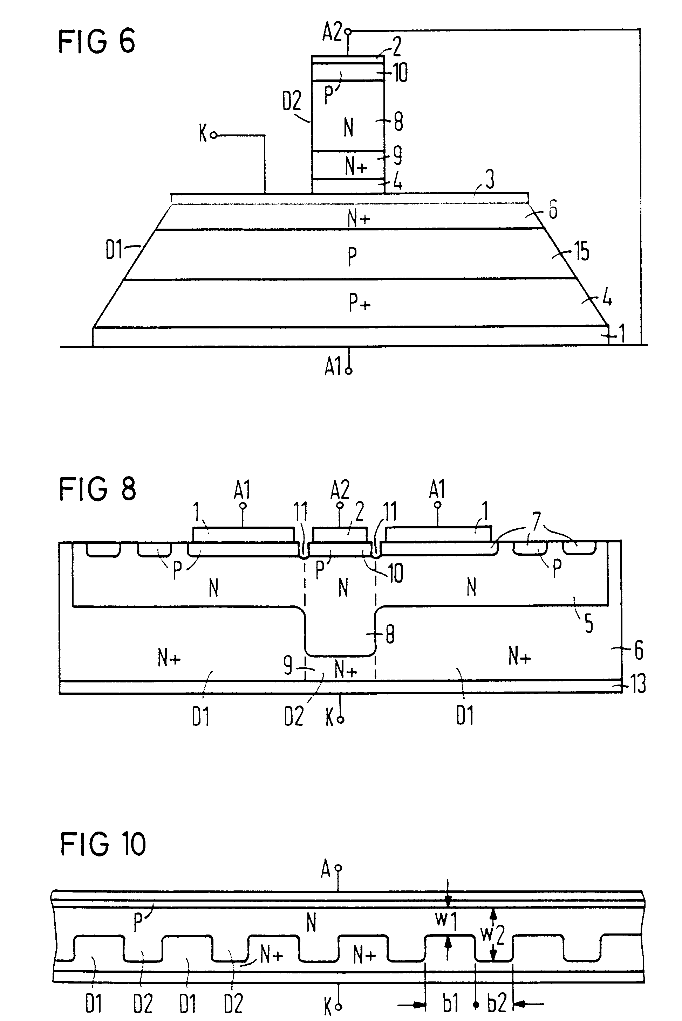

Alternativ zu den bisherigen Ausführungsformen kann die Innenzone der Teildiode D1 schwach p-leitend (Figur 6) ausgebildet sein, so daß dann eine $PP^-N^+$-Struktur vorliegt. Dies hat zur Folge, daß der pn-Übergang der Diode D1, der nun zwischen Innenzone 15 und dem $N^+$-Gebiet 6 liegt, erste später von Ladungsträgern freigeräumt wird und später Spannung aufnimmt als bei der $PNN^+$-Struktur. Die Diode D1 hat daher ein besonders hartes Recovery-Verhalten; jedoch hat dies im Verbund mit der Soft-Recovery-Diode D2 keinen Nachteil. Bei Dioden, deren Anodenanschluß auf gleichem Potential mit dem Gehäuse liegt, kann eine solche Struktur aber Vorteile in der Aufbautechnik haben. Das Diodenchip D2 mit der kleineren Fläche kann dann mit der katodenseitigen Kontaktmetallschicht auf die Katodenmetallschicht des Diodenchips D2 aufgebracht werden, wie Figur 6 zeigt. Ein solcher Aufbau erfordert keinen zusätzlichen Platz.

Gemäß einer Weiterbildung der Erfindung kann zwischen den Anodenelektroden 1, 2 der Teildioden eine Streuinduktivität $L_i$ eingeschaltet werden. Die Teildiode D1 ist direkt mit dem Anodenkontakt A der Diode verbunden. Da im Rückstrommaximum der Gesamtdiode der Rückstrom $i_{R2}$ der Teildiode D2 noch ansteigt (siehe Figur 3), liegt zu diesem Zeitpunkt an der Diode D2 nun noch nicht die volle Kreisspannung $U_{R0}$ an, sondern eine um $L_i di_{R2}/dt$ verringerte Spannung. Infolgedessen ist die Speicherladung $Q_{F2}$ noch nicht so weit ausgeräumt, wie es der Spannung $U_{R0}$ entspricht (Verkleinerung von e in Gl. 3)), so daß der Rückstrom $i_{RM}$ reduziert wird. Die Streuinduktivität kann praktisch dadurch realisiert werden, daß die Anodenelektrode 2 der Teildiode D2 nur über einen Bonddraht zur Anodenelektrode 1 der Teildiode D1 mit dem Anodenkontakt A der Gesamtdiode verbunden ist. Der Bonddraht zur Teildiode D1 und eine dadurch verursachte Streuinduktivität, die beiden Teildioden vorgeschaltet ist, wird hierbei nicht der Diodeneinheit D, sondern der äußeren Schaltung zugerechnet. Schon ein Bonddraht von 1 cm Länge und 200 $\mu$m Dicke, dessen Streuinduktivität $L_i$ 9.1 nH beträgt, führt zu einer merklichen Verbesserung des Recovery-Verhaltens der Diodeneinheit.

In den Figuren 3 und 4 sind Kommutierungsvorgänge dargestellt, bei denen die Rückspannung $U_R$ nicht bis in den Durchbruchbereich der dünneren Teildiode ansteigt. Anders als bei den bekannten Dioden führt ein solches Ansteigen der Spannung bis in den Durchbruch bei der erfindungsgemäßen Diodeneinheit nicht zur Zerstörung oder elektromagnetischer Interferenz durch hochfrequente Schwingungen.

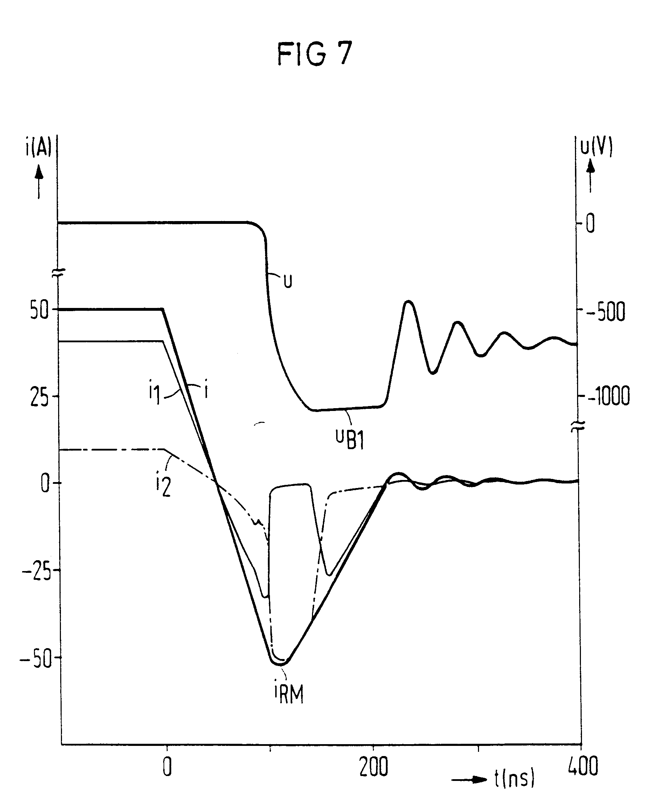

In Figur 7 sind Strom- und Spannungsverlauf der beiden Teildioden und der Diodeneinheit für eine Kommutierung dargestellt, bei der die Spannung die Durchbruchspannung $U_{B1}$ der Teildiode D1 erreicht. Wie zu erkennen, knickt die Spannung bei $U_{B1}$ = 1100 V in ein flaches Plateau um. Der Rückstrom $i_{R1}$ aus der Diode D1, der schon auf Null abgefallen war, steigt zu diesem Zeitpunkt durch Avalanche-Generation wieder an. Dadurch wird die Abnahme des Gesamtrückstroms $i_R = i_{R1} + i_{R2}$ auf den Wert begrenzt, den die verfügbare Spannungsdifferenz an der Induktivität $L_e$ zuläßt: $L_e di_R/dt = U_{B1} - U_{R0}$. Insgesamt ist ein sehr zufriedenstellendes Recovery-Verhalten zu beobachten. Die Durchbruchspannung der Diode D1 kann nun durch die geringe Dicke und Dotierung der Basiszone kleiner gemacht werden als die Spannung, die zu einem Durchbruch an der Oberfläche führt. Ohne das Soft-Recovery-Verhalten der Diodeneinheit aufzugeben, wird also die Spannung durch die Diodeneinheit selbst so begrenzt, daß keine Zerstörung auftritt.

Wie Figur 7 zeigt, treten auch keine hochfrequente Schwingungen auf. Sie entstehen bei herkömmlichen Dioden wenn ein Stromabriß die Spannung in den Durchbruch treibt, wodurch Avalanche-Strom generiert wird und die Spannung wegen des nun verkleinerten $\frac{di}{dt}$ zurückschwingt, was dann wegen fehlender Avalanche-Generation wieder zu Stromabriß führt usw.. Bei der Diodeneinheit nach der Erfindung treten diese Schwingungen trotz der Avalanche-Generation in der Teildiode D1 nicht auf, weil die Diode mit der dicken Basis bei der begrenzten Spannung noch genügend Restladung bereit hält, um es nicht zu Stromabrissen kommen zu lassen.

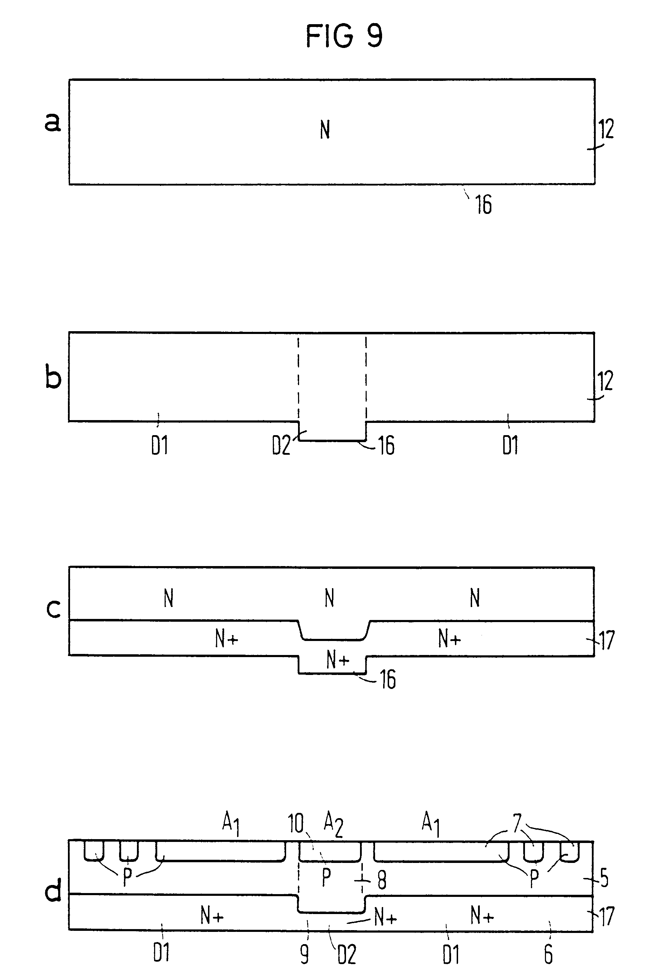

Eine Ausführungsform der erfindungsgemäßen Diode, bei der die beiden Teildioden auf einem Halbleiterchip integriert sind, zeigt Figur 8. Die unterschiedliche Basisdicke in den Bereichen D1 und D2 wird bei der dargestellten Ausführungsform dadurch erreicht, daß die $N^+$-Zone verschieden tief eindiffundiert ist, während die Dicke des Halbleiterkörpers in beiden Bereichen gleich ist. Die Anodenelektroden 1, 2 wie auch die anliegenden Halbleiterzonen können zwischen den Teildioden D1 und D2 durch Gräben 11 unterbrochen sein, so daß beide Bereiche getrennt mit Anodenanschlüssen versehen werden können. Ebenso ist es möglich, auch die Katodenelektroden zu trennen. Die Fläche der Teildiode D2 beträgt z. B. 4 mm$^2$, die Fläche der Teildiode D1 25 mm$^2$.

Die Herstellung einer Struktur gemäß Figur 8 ist in Figur 9 schematisch angegeben. Ein schwach n-leitender Halbleiterkörper 12 (Figur 9a) wird an seiner katodenseitigen Hauptfläche 16 z. B. durch Ätzen in der Dicke strukturiert (b), so daß unterschiedlich dicke Bereiche für die Teildioden D1, D2 entstehen. Anschließend wird von der Hauptfläche 16 her eine $n^+$-dotierte Schicht 17 eindiffundiert (c). Dann wird der Halbleiterkörper katodenseitig z. B. durch Schleifen geebnet. Anschließend werden die anodenseitigen Zonen 7, 10 eindiffundiert (d). Die unterschiedliche Minoriätsträgerlebensdauer für D1 bzw. D2 kann nach bekannten Verfahren z. B. durch Abschirmung beim Elektronenbestrahlen oder durch lateral maskiertes Ausheilen der Bestrahlungsschäden erfolgen.

Eine andere Ausführungsform der Erfindung ist in Figur 10 dargestellt. Die in einem Halbleiterchip angeordneten Bereiche kleiner und großer Basisdicke $w_1$ und $w_2$ haben hier eine geringe laterale Ausdehnung. Die Diodeneinheit besteht aus einer Vielzahl von gleichen Untereinheiten mit jeweils einem Bereich kleiner und großer Basisdicke. Die Unterbereiche sind vorzugsweise streifenförmig. Die Minoritätsträgerlebensdauer und Dotierungskonzentration der Basiszone sind in den Bereichen kleiner und großer Basisdicke gleich. Die Breite b2 der Streifen mit großer Basisdicke w2 wird so gewählt, daß der Strom aus den vertikal verlaufenden Teilen des $NN^+$-Übergangs einen wesentlichen Teil des Gesamtstroms in den Bereichen mit großer Basisdicke ausmacht. Dazu wird die laterale Breite $b_2$ dieser Streifen maximal gleich dem doppelten Betrag der zusätzlichen Basisdicke gewählt: $b_2 \leqq 2(w_2 - w_1)$. Die Breite $b_1$ der Streifen mit geringer Basisdicke ist von etwa gleicher Größe wie $b_2$. Beispielsweise ist $w_1 = 60\,\mu m$, $w_2 = 120\,\mu m$ und $b_1 = b_2 = 100\,\mu m$. Trotz der gleichen Lebensdauer kann auf diese Weise die Ladung, die in den Bereichen großer Basisdicke zur Zeit der Rückstromspitze noch gespeichert ist, auf eine Größe gebracht werden, die mit der bis dahin schon extrahierten Ladung $Q_{rs}$ vergleichbar ist. Da andererseits der maximale Rückstrom ähnlich wie oben beschrieben durch die Bereiche kleiner Basisdicke reduziert wird, ergeben sich auf diese Weise bessere Rückwärtserholungseigenschaften als bei den bekannten Dioden.

Die Erfindung ist außer in den beschriebenen Ausführungsbeispielen auch dort anwendbar, wo eine der Dioden bereits in ein Bauelement integriert ist. Dies ist z. B. bei Leistungs-MOSFETs der Fall, bei denen eine bezogen auf die in Durchlaßrichtung gepolte Drain-Sourcestrecke in Sperrichtung gepolte Inversdiode vorhanden ist. Solche Dioden werden gelegentlich mit Rekombinationszentren dotiert und können ein hartes Rückwärtserholungsverhalten aufweisen. Wird der Inversdiode eine Diode mit dickerer Innenzone und einer Fläche parallel geschaltet, daß sich die o.a. Stromaufteilung einstellt, so ergibt sich ein Soft-Recovery-Verhalten bei geringerer Rückstromspitze Es ist außerdem möglich, die Erfindung z. B. bei rückwärts leitenden Thyristoren einzusetzen, deren integrierte Diode i.a. ein Soft-Recovery-Verhalten hat, aber eine hohe Rückstromspitze. Dieser Diode kann nun eine externe Diode mit dünnerer Innenzone parallel geschaltet werden, die im Verhältnis zur integrierten Diode nach den oben genannten Gesichtspunkten bemessen wird und ein hartes Rückwärtserholungsverhalten mit geringer Rückstromspitze hat.

**Patentansprüche**

1.  Leistungsdiode mit mindestens einem Halbleiterkörper, der eine Innenzone (5) vom ersten Leitfähigkeitstyp und gegebener Dotierungshöhe hat, eine Katodenzone (6) vom ersten Leitfähigkeitstyp und höherer Dotierung als die Innenzone, eine Anodenzone (7) vom entgegengesetzten, zweiten Leitfähigkeitstyp und höherer Dotierung als die Innenzone und bei dem die Innenzone mindestens zwei Bereiche hat, von denen der erste eine erste vorgegebene Dicke (w1) und der zweite eine zweite, um mindestens den Faktor 1,4 größere Dicke (w2) aufweist, wodurch zwei Teildioden (D1, D2) definiert werden,
    **dadurch gekennzeichnet,** daß die Dicke (w1) des ersten Bereichs der geforderten Sperrspannung entspricht und daß die Fläche und die Minoritätsträgerlebensdauer in der ersten und zweiten Teildiode (D1, D2) so bemessen sind, daß der durch die erste Teildiode (D1) fließende Strom in der Durchlaßphase mindestens um den Faktor 2 größer ist als der durch die zweite Teildiode (D2) fließende Strom.

2.  Leistungsdiode nach Anspruch 1,
    **dadurch gekennzeichnet,** daß die Dotierungskonzentrationen der Innenzonen (5, 8) der beiden Teildioden (D1, D2) einander gleich sind.

3.  Leistungsdiode nach Anspruch 1,
    **dadurch gekennzeichnet,** daß die Dotierungskonzentration der Innenzone (8) der zweiten Teildiode (D2) größer ist als die Dotierungskonzentration der Innenzone (5) der ersten Teildiode (D1).

4.  Leistungsdiode nach Anspruch 1,
    **dadurch gekennzeichnet,** daß die Teildioden (D1, D2) derart dimensioniert sind, daß die zweite Teildiode (D2) in Durchlaßrichtung eine Speicherladung hat, die dem 0,5 bis 2fachen der Speicherladung in Durchlaßrichtung der ersten Teildiode (D1) entspricht.

5.  Leistungsdiode nach Anspruch 4,
    **dadurch gekennzeichnet,** daß die Speicherladungen in Durchlaßrichtung beider Teildioden (D1, D2) gleich sind.

6.  Leistungsdiode nach Anspruch 5,
    **dadurch gekennzeichnet,** daß die Teildioden (D1, D2) derart dimensioniert sind, daß sich der Quotient der Durchlaßströme ($i_{F1}/i_{F2}$) der beiden Teildioden etwa umgekehrt proportional zum Quadrat des Quotienten der Dicken (w1/w2) des ersten und zweiten Bereiches der Innenzone (5) verhält.

7.  Leistungsdiode nach Anspruch 6,
    **dadurch gekennzeichnet,** daß die Flächen der Teildioden (D1, D2) so aufeinander abgestimmt sind, daß ihre Durchlaßstromdichten wenigstens annähernd gleich sind.

8. Leistungsdiode nach Anspruch 7,
   **dadurch gekennzeichnet,** daß die Fläche der ersten Teildiode (D1) 3 bis 15mal größer ist als die Fläche der zweiten Teildiode (D2).

9. Leistungsdiode nach Anspruch 1,
   **dadurch gekennzeichnet,** daß der zweite Bereich etwa doppelt so dick ist wie der erste.

10. Leistungsdiode nach Anspruch 1,
    **dadurch gekennzeichnet,** daß die Teildioden (D1, D2) derart dimensioniert sind, daß der durch die zweite Teildiode (D2) fließende Durchlaßstrom 1/4 bis 1/8 des Durchlaßstroms der ersten Teildiode (D1) beträgt.

11. Leistungsdiode nach Anspruch 1,
    **dadurch gekennzeichnet,** daß die Anodenzone (10) der zweiten Teildiode (D2) schwächer dotiert ist als die Anodenzone (7) der ersten Teildiode (D1).

12. Leistungsdiode nach Anspruch 1,
    **dadurch gekennzeichnet,** daß die Teildioden (D1, D2) in einen Halbleiterkörper integriert sind.

13. Leistungsdiode nach Anspruch 1,
    **dadurch gekennzeichnet,** daß die Teildioden (D1, D2) separate Halbleiterkörper haben und daß ihre Katodenelektroden (3, 4) und ihre Anodenelektroden (1, 2) elektrisch miteinander verbunden sind.

14. Leistungsdiode nach Anspruch 13,
    **dadurch gekennzeichnet,** daß zwischen die Anodenelektroden (1, 2) der Teildioden (D1, D2) eine Induktivität (Li) geschaltet ist.

15. Leistungsdiode mit mindestens einem Halbleiterkörper, der eine Innenzone vom ersten Leitfähigkeitstyp und gegebener Dotierungshöhe hat, eine Katodenzone vom ersten Leitfähigkeitstyp und höherer Dotierung als die Innenzone, eine Anodenzone vom entgegengesetzten, zweiten Leitfähigkeitstyp und höherer Dotierung als die Innenzone und bei dem die Innenzone eine Vielzahl von ersten und zweiten Bereichen hat, von denen die ersten eine erste vorgegebene Dicke und die zweiten eine zweite, um mindestens den Faktor 1,4 größere Dicke aufweisen, wodurch zwei Teildioden (D1, D2) definiert werden,
    **dadurch gekennzeichnet,** daß die Dicke (w1) der ersten Bereiche der geforderten Sperrspannung entspricht, daß die Minoritätsträgerlebensdauer in der ersten und zweiten Teildiode (D1, D2) gleich sind und daß die Breite (b2) der Bereiche mit großer Dicke (w2) maximal dem doppelten Betrag der Differenz der Dicken (w1-w2) der Bereiche ist.

## Claims

1. Power diode having at least one semiconductor body, which has an inner zone (5) of the first conductivity type and given doping level, a cathode zone (6) of the first conductivity type and higher doping than the inner zone, an anode zone (7) of the opposite, second conductivity type and higher doping than the inner zone, and in the case of which the inner zone has at least two regions, the first of which has a first predetermined thickness (w1) and the second of which has a second thickness (w2) which is larger by at least a factor of 1.4, as a result of which two partial diodes (D1, D2) are defined, characterized in that the thickness (w1) of the first region corresponds to the required reverse voltage, and in that the area and the minority carrier life in the first and second partial diodes (D1, D2) are dimensioned in such a way that the current flowing through the first partial diode (D1) in the conducting-state phase is larger by at least a factor of 2 than the current flowing through the second partial diode (D2).

2. Power diode according to Claim 1, characterized in that the doping concentrations of the inner zones (5, 8) of the two partial diodes (D1, D2) are equal to one another.

3. Power diode according to Claim 1, characterized in that the doping concentration of the inner zone (8) of the second partial diode (D2) is larger than the doping concentration of the inner zone (5) of the first partial diode (D1).

4. Power diode according to Claim 1, characterized in that the partial diodes (D1, D2) are dimensioned in such a way that the second partial diode (D2) has a storage charge in the conducting direction which corresponds to 0.5 to 2 times the storage charge in the conducting direction of the first partial diode (D1).

5. Power diode according to Claim 4, characterized in that the storage charges in the conducting direction of both partial diodes (D1, D2) are equal.

6. Power diode according to Claim 5, characterized in that the partial diodes (D1, D2) are dimensioned in such a way that the quotient of the conducting-state currents ($i_{F1}/i_{F2}$) of the two partial diodes is approximately inversely proportional to the square of the quotient of the thicknesses (w1/w2) of the first and second regions of the inner zone (5).

7. Power diode according to Claim 6, characterized in that the areas of the partial diodes (D1, D2) are matched to one another in such a way that their conducting-state current densities are at least approximately equal.

8. Power diode according to Claim 7, characterized in that the area of the first partial diode (D1) is 3 to 15 times larger than the area of the second partial diode (D2).

9. Power diode according to Claim 1, characterized in that the second region is approximately twice as thick as the first.

10. Power diode according to Claim 1, characterized in that the partial diodes (D1, D2) are dimensioned in such a way that the conducting-state current flowing through the second partial diode (D2) is 1/4 to 1/8 of the conducting-state current of the first partial diode (D1).

11. Power diode according to Claim 1, characterized in that the anode zone (10) of the second partial diode (D2) is doped more weakly than the anode zone (7) of the first partial diode (D1).

12. Power diode according to Claim 1, characterized in that the partial diodes (D1, D2) are integrated in a semiconductor body.

13. Power diode according to Claim 1, characterized in that the partial diodes (D1, D2) have separate semiconductor bodies and in that their cathode electrodes (3, 4) and their anode electrodes (1, 2) are electrically connected to one another.

14. Power diode according to Claim 13, characterized in that an inductance ($L_l$) is connected between the anode electrodes (1, 2) of the partial diodes (D1, D2).

15. Power diode having at least one semiconductor body, which has an inner zone of the first conductivity type and given doping level, a cathode zone of the first conductivity type and higher doping than the inner zone, an anode zone of the opposite, second conductivity type and higher doping than the inner zone, and in the case of which the inner zone has a multiplicity of first and second regions, the first of which have a first predetermined thickness and the second of which have a second thickness which is larger by at least a factor of 1.4, as a result of which two partial diodes (D1, D2) are defined, characterized in that the thickness (w1) of the first regions corresponds to the required reverse voltage, in that the minority carrier life is the same in the first and second partial diodes (D1, D2), and in that the width (b2) of the regions of large thickness (w2) is at most twice the difference between the thicknesses (w1-w2) of the regions.

**Revendications**

1. Diode de puissance comportant au moins un corps semiconducteur, qui a une zone intérieure (5) d'un premier type de conductivité et un niveau de dopage donné, une zone de cathode (6) du premier type de conductivité et d'un dopage supérieur à celui de la zone intérieure, une zone d'anode (7) du second type de conductivité opposé et d'un dopage supérieur à celui de la zone intérieure, la zone intérieure ayant au moins deux régions, dont la première a une première épaisseur prédéterminée (w1) et dont la seconde a une seconde épaisseur (w2) supérieure au moins du facteur 1,4 à la première épaisseur, ce qui définit deux diodes partielles (D1,D2),

caractérisée par le fait que l'épaisseur (w1) de la première région correspond à la tension de blocage requise et que la surface et la durée de vie des porteurs minoritaires dans les première et seconde diodes partielles (D1,D2) sont telles que le courant traversant la première diode partielle (D1) est, pendant la phase d'état passant, supérieure au moins du facteur 2 au courant circulant dans la seconde diode partielle (D2).

2. Diode de puissance suivant la revendication 1, caractérisée par le fait que les concentrations de dopage des zones intérieures (5,8) des deux diodes partielles (D1,D2) sont égales.

3. Diode de puissance suivant la revendication 1, caractérisée par le fait que la concentration de dopage de la zone intérieure (8) de la seconde diode partielle (D2) est supérieure à la concentration de dopage de la zone intérieure (5) de la première diode partielle (D1).

4. Diode de puissance suivant la revendication 1, caractérisée par le fait que les diodes partielles (D1 et D2) sont dimensionnées de telle sorte que la seconde diode partielle (D2) a, dans le sens passant, une charge stockée, qui correspond à 0,5 à 2 fois la charge stockée dans le sens passant de la première diode partielle (D1).

5. Diode de puissance suivant la revendication 4, caractérisée par le fait que les charges stockées dans le sens passant des deux diodes partielles (D1,D2) sont égales.

6. Diode de puissance suivant la revendication 5, caractérisée par le fait que les diodes partielles (D1,D2) sont dimensionnées de telle sorte que le quotient des courants à l'état passant ($i_{F1}$,$i_{F2}$) des deux diodes partielles est approximativement inversement proportionnel au carré du quotient des épaisseurs (w1/w2) des première et seconde régions de la zone intérieure (5).

7. Diode de puissance suivant la revendication 6, caractérisée par le fait que les surfaces des diodes partielles (D1,D2) sont accordées l'une sur l'autre de telle sorte que leurs densités de courant à l'état passant soient au moins approximativement égales.

8. Diode de puissance suivant la revendication 7, caractérisée par le fait que la surface de la première diode partielle (3) est supérieure de 3 à 15 fois à la surface de la seconde diode partielle (D2).

9. Diode de puissance suivant la revendication 1, caractérisé par le fait que la seconde région a une épaisseur égale approximativement au double de celle de la première région.

10. Diode de puissance suivant la revendication 1, caractérisée par le fait que les diodes partielles (D1,D2) sont telles que le courant à l'état passant, qui traverse la seconde diode partielle (D2) est compris entre 1/4 et 1/8 du courant à l'état passant de la première diode (D1).

11. Diode de puissance suivant la revendication 1, caractérisée par le fait que la zone d'anode (10) de la seconde diode partielle (D2) est plus faiblement dopée que la zone d'anode (7) de la première diode partielle (D1).

12. Diode de puissance suivant la revendication 1, caractérisée par le fait que les diodes partielles (D1,D2) sont intégrées à un corps semiconducteur.

13. Diode de puissance suivant la revendication 1, caractérisée par le fait que les diodes partielles (D1,D2) ont des corps semiconducteurs séparés et que leurs électrodes de cathode (3,4) et leurs électrodes d'anode (1,2) sont reliées électriquement entre elles.

14. Diode de puissance suivant la revendication 13, caractérisée par le fait qu'une inductance (Li) est branchée entre les électrodes d'anode (1,2) des diodes partielles (D1,D2).

15. Diode de puissance comportant au moins un corps semiconducteur, qui a une zone intérieure d'un premier type de conductivité et un niveau de dopage donné, une zone de cathode du premier type de conductivité et d'un dopage supérieur à celui de la zone intérieure, une zone d'anode du second type de conductivité opposé et d'un dopage supérieur à celui de la zone intérieure, la zone intérieure ayant une pluralité de premières et secondes régions, dont les premières ont une première épaisseur prédéterminée et dont les secondes ont une seconde épaisseur supérieure au moins du facteur 1,4 à la première épaisseur, ce qui définit deux diodes partielles (D1,D2),
caractérisée par le fait que l'épaisseur (w1) des premières régions correspond à la tension de blocage requise, que la durée de vie des porteurs minoritaires dans les première et seconde diodes partielles (D1,D2) sont égales et que la largeur (b2) des régions ayant la grande épaisseur (w2) est égale au maximum au double de la valeur absolue de la différence des épaisseurs (w1-w2) des régions.

## FIG 1

## FIG 2

# FIG 3

## FIG 4

FIG 5

EP 0 551 625 B1

FIG 6

A2

2
10
D2    P'
N     8
9
N+    4
3
6
D1    N+
P     15
P+    4
1
A1    K

FIG 8

1    A1    11    A2  2    11    A1    1    7
P                P'                        P
N    10
N    N    N    5
8    6
N+    9    N+    N+    13
D1    D2    D1
K

FIG 10

A
P    N    w1
w2
N+    N+
D1  D2  D1  D2    b1    b2
K

17

# FIG 7

# FIG 9